# EUROPEAN PATENT SPECIFICATION

(11) **EP 0 342 937 B1**
(45) Date of publication and mention of the grant of the patent: **27.07.1994**
(21) Application number: 89304953.6
(22) Date of filing: 16.05.1989
(51) Int. Cl.: H01L 21/20

(54) **Manufacturing a semiconductor wafer having a III-V group semiconductor compound layer on a silicon substrate**
Herstellung eines Halbleiterplättchens, das eine III-V-Gruppen-Halbleiterverbindungsschicht auf einem Siliziumsubstrat aufweist
Fabrication d'une plaquette semi-conductrice ayant une couche d'un composé semi-conducteur du groupe III-V sur un substrat en silicium

(30) Priority: 17.05.1988 JP 118224/88
(43) Date of publication of application: 23.11.1989
(73) Proprietor: FUJITSU LIMITED, Kawasaki-shi, Kanagawa 211 (JP)
(72) Inventor: Takasaki, Kanetake, Tokyo 143 (JP)
(74) Representative: Fane, Christopher Robin King

(56) References cited:
- EP-A- 0 159 252
- EP-A- 0 193 298
- APPLIED PHYSICS LETTERS, vol. 50, no. 1, 5th January 1987, pages 31-33, American Institute of Physics, New York, NY, US; J.W. LEE et al.: "Defect reduction by thermal annealing of GaAs layers grown by molecular beam epitaxy on Si substrates"
- APPLIED PHYSICS LETTERS, vol. 48, no. 22, 2nd June 1986, pages 1516-1518, American Institute of Physics, New York, NY, US; A. CHRISTOU et al.: "Formation of (100) GaAs on (100) silicon by laser recrystallization"

## Description

The present invention relates to manufacturing a semiconductor wafer having a III-V group semiconductor compound layer on a silicon substrate, and, more particularly, to a method of growing a III-V group compound semiconductor crystalline thin film of, for example, GaAs or the like on a silicon substrate.

Heteroepitaxial growth of a III-V group compound semiconductor crystalline thin film of, for example, GaAs or the like, on a silicon (Si) substrate can be carried out by a Metalorganic Chemical Vapour Deposition (MOCVD) process or a Molecular Beam Epitaxy (MBE) process.

The crystal lattice constants of Si and GaAs are 0.543nm and 0.565nm (5.43 Å and 5.65 Å) respectively, and the thermal expansion coefficients thereof are 2.6 x 10⁻⁶/°C and 5.9 x 10⁻⁶/°C, respectively.

Accordingly, since the crystal lattice constant and, in particular, the thermal expansion coefficient of Si differ from those of GaAs, when a GaAs layer is formed on a Si substrate by the MOCVD process, the GaAs is formed thereon in a polycrystalline state. Therefore, according to a previously-considered method, after an amorphous GaAs layer is grown on a Si substrate to a thickness of 10nm to 20nm (100 to 200Å) at a temperature of about 450°C, crystalline GaAs is grown to a thickness of 3 to 5 µm at a temperature of 700 to 750°C, thereby obtaining a GaAs single crystalline thin film by a two-step process in which the mismatching of the respective lattice constants of Si and GaAs is relaxed, i.e. the problem is overcome, by the occurrence of defects at the interface between the Si and GaAs.

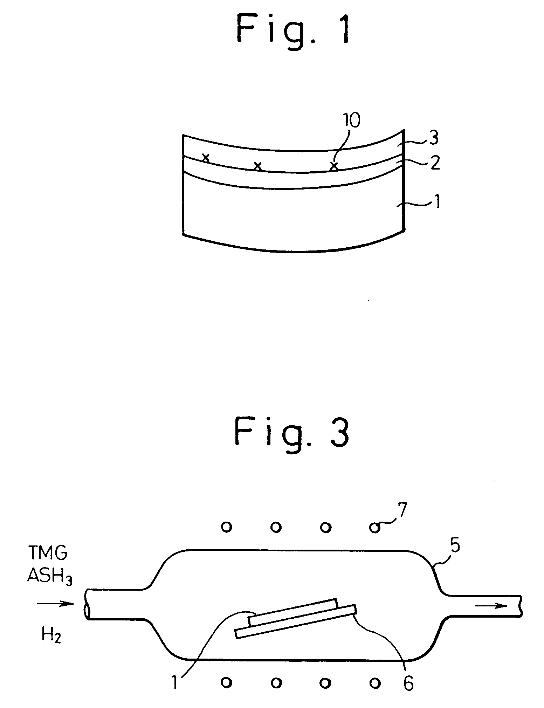

Owing to the large disparity in the respective thermal expansion coefficients, however, even if GaAs is grown on a Si substrate by the above-mentioned two-step growth process, when the temperature of the substrate is changed to room temperature after the growth of GaAs, significant warping of the substrate tends to occur and the GaAs surface tends to become concave, as shown in Fig. 1 of the accompanying drawings.

When GaAs is grown to a thickness of 3µm or more, a tension stress stronger than 1 x 10⁸ Pa (10⁹ dyn/cm²) or more is generated, and therefore, when the substrate is subjected to a heat treatment after the GaAs growth, lattice defects such as dislocation and the like are formed therein which result in cracks 10 (Fig. 1), and thus, in practice, the formation of a GaAs layer on an Si substrate is not considered viable. In Fig. 1, the reference numerals 1, 2 and 3 denote a silicon (Si) substrate, an amorphous GaAs layer and a GaAs crystalline layer, respectively.

Accordingly, it is desirable to provide an heteroepitaxial growth method whereby, when a III-V group compound semiconductor such as GaAs or the like is grown on a silicon substrate, stress at the hetero-interface between the silicon substrate and the GaAs layer may be reduced and a wafer may be obtained in which warping is greatly reduced.

According to the present invention there is provided a method of manufacturing a semiconductor wafer comprising the steps of forming a first amorphous layer of a III-V group semiconductor compound on a silicon substrate, and forming a first monocrystalline layer of said semiconductor compound on the said amorphous layer; characterised by the further steps of forming a second amorphous layer of the said semiconductor compound on the first monocrystalline layer, and bringing about solid phase epitaxial growth, from the said first monocrystalline layer, through the said second amorphous layer so as to transform that second amorphous layer into a second monocrystalline layer of the said semiconductor compound.

Desirably, the said semiconductor material consists of the said III-V group semiconductor compound.

Preferably, in a method embodying the present invention formation of said first amorphous layer is carried out at a first temperature, formation of said first monocrystalline layer is carried out at a second temperature higher than said first temperature, formation of said second amorphous layer is carried out at a third temperature lower than said second temperature, and transformation of said second amorphous layer into said second monocrystalline layer is carried out at a fourth temperature between said second temperature and said third temperature.

Desirably, in such a method said second amorphous layer has a thickness greater than that of said first monocrystalline layer.

Reference will now be made, by way of example, to the accompanying drawings, in which:-
Fig. 1 (described above) shows a cross-sectional view of a wafer formed by the previously-considered method;
Figs. 2A to 2D show cross-sectional views illustrating respective steps in a method embodying the present invention;
Fig. 3 shows a schematic view of apparatus suitable for use with a method embodying the present invention; and
Figs. 4 and 5 are graphs.

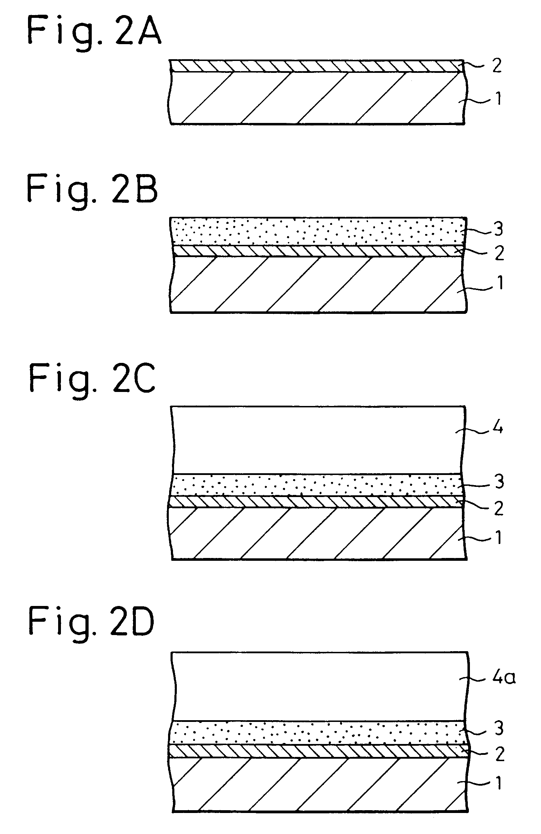

As shown in Fig. 2A, the first step of a method embodying the present invention comprises forming a first amorphous GaAs layer 2 having a thickness of 10nm to 20nm (100Å to 200Å) on a silicon substrate 1 having a diameter of approximately 5cm (2 inches), at a temperature of 450°C, by a usual MOCVD process.

Then, as shown in Fig. 2B, a GaAs crystal layer 3 having a thickness of 100nm to 200nm (1000 to 2000 Å) is formed on the first amorphous GaAs layer 2, at a temperature of 700 to 750°C, using a usual MOCVD process.

Then, as shown in Fig. 2C, a second amorphous GaAs layer 4 having a thickness of about 3 to 5 µm is formed on the GaAs crystal layer 3, at a temperature of 400° - 450°C.

The conditions for the above-mentioned MOCVD were as follows.

Namely, trimethyl-gallium (TMG: (CH₃)₃Ga) was used as a source gas of gallium (Ga), at a TMG supply rate of 15 cm³/min (15cc/min). Further, arsine (AsH₃) was used as a source gas of arsenic (As), at a AsH₃ supply rate of 450 cm³/min (450cc/min), and H₂ gas was used at a supply rate of 10 ℓ/min, as a carrier gas of the source gases, TMG and AsH₃.

The above-mentioned heat treatment was carried out by using an inductive heating method.

After forming the second amorphous GaAs layer 4, the obtained substrate is annealed at a temperature lower than the temperature of 700 to 750°C at which the GaAs crystal layer 3 was formed, for example at about 500 to about 650°C, using an atmosphere containing AsH₃ supplied at a rate of 100 cm³/min (100cc/min) and H₂ supplied at a rate of 1 ℓ/min, whereby solid phase epitaxial growth is carried out from the GaAs crystal layer 3 and the amorphous GaAs layer 4 gradually changes to a GaAs crystal layer 4a, from the lower portion thereof. Warping of a thus-obtained GaAs crystal - Si substrate (wafer) can be reduced from the conventional 60 µm to about 20 µm.

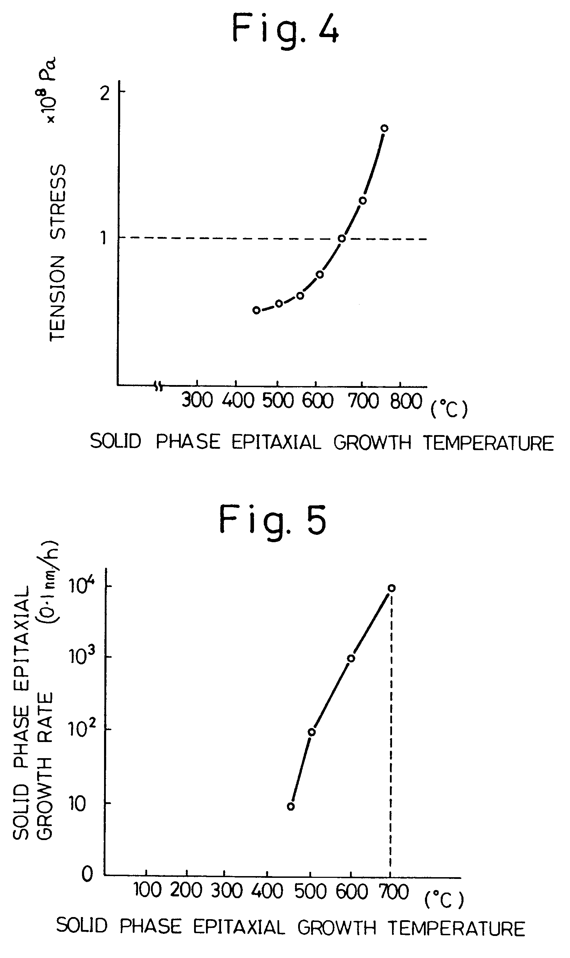

Figure 3 illustrates schematically a main reacting portion of MOCVD apparatus which is suitable for use in carrying out the above-described method. As shown in Fig. 3, a silicon substrate (wafer) 1 is provided on a carbon susceptor 6 provided in an MOCVD reacting vessel 5 which is inductively heated using a heating coil 7. The reacting gases TMG and AsH₃, or the carrier gas H₂, is supplied to the vessel to form a GaAs layer (not shown).

As explained above, although the solid phase epitaxial growth from the GaAs crystal layer 3 is carried out at a temperature of about 500 to about 650°C, the tension stress in a GaAs layer obtained at a temperature below 650°C is 1 x 10⁸ Pa (1 x 10⁹ dyn/cm²) or less, as shown in Fig. 4, which illustrates the relationship between the tension stress in the GaAs layer and the solid phase epitaxial growth temperature.

Figure 5 shows the relationship between the solid phase epitaxial growth rate and the solid phase epitaxial growth temperature.

As can be seen in Fig. 5, the solid phase epitaxial growth rate is significantly less when the temperature is less than 500°C than when the temperature is in the preferred range from 500 to 650°C.

Although an MOCVD process was used in the above-explained example, wherein GaAs is grown on a Si substrate, a well-known MBE (Molecular Beam Epitaxy) process can also be used when, for example, forming an amorphous GaAs layer 2 on a Si substrate at a temperature of about 150 to about 400°C.

Further, in an embodiment of the present invention, GaP, GaAsₓP₁₋ₓ, InₓGa₁₋ₓAs, Ga₁₋ₓAsₓP₁₋ₓ or InP can be used as the III-V group semiconductor compound instead of GaAs.

As explained above, according to an embodiment of the present invention the warping and the stress of a wafer obtained by heteroepitaxial growth, for example a GaAs growth on a Si substrate, can be decreased in comparison with a wafer produced by a previously-considered method, thereby enabling, for example, a shift of the threshold voltage (Vth) etc. of the FET's which are fabricated on GaAs to be prevented.

## Claims

1. A method of manufacturing a semiconductor wafer comprising the steps of forming a first amorphous layer (2) of a III-V group semiconductor compound on a silicon substrate (1), and forming a first monocrystalline layer (3) of said semiconductor compound on the said amorphous layer (2);
characterised by the further steps of forming a second amorphous layer (4) of the said semiconductor compound on the first monocrystalline layer (3), and bringing about solid phase epitaxial growth, from the said first monocrystalline layer (3), through the said second amorphous layer (4) so as to transform that second amorphous layer (4) into a second monocrystalline layer (4a) of the said semiconductor compound.

2. A method as claimed in claim 1, wherein said III-V group semiconductor compound is selected from the group comprising GaAs, GaP, GaAsₓP₁₋ₓ, InₓGa₁₋ₓAs, InₓGa₁₋ₓAsₓP₁₋ₓ, and InP.

3. A method as claimed in claim 1 or 2, wherein said first amorphous layer (2) has a thickness of about 10nm to 20 nm and is formed at a temperature in the range from 400°C to 450°C.

4. A method as claimed in any preceding claim, wherein said second amorphous layer (4) has a thickness of about 2µm to 5µm and is formed at a temperature in the range from 400°C to 450°C.

5. A method as claimed in any preceding claim, wherein solid phase epitaxial growth is brought about after the formation of the said second amorphous layer (4) by carrying out an annealing process at a temperature lower than that at which said first monocrystalline layer (3) was formed.

6. A method as claimed in claim 5, wherein said temperature is in the range from about 500°C to about 650°C.

7. A method as claimed in any preceding claim, carried out by using a Metal organic Chemical Vapour Deposition (MOCVD) process or a Molecular Beam Epitaxy (MBE) process.

8. A method as claimed in any preceding claim, wherein formation of said first amorphous layer (2) is carried out at a first temperature, formation of said first monocrystalline layer (3) is carried out at a second temperature higher than said first temperature, formation of said second amorphous layer (4) is carried out at a third temperature lower than said second temperature, and transformation of said second amorphous layer (4) into said second monocrystalline layer (4a) is carried out at a fourth temperature between said second temperature and said third temperature.

9. A method as claimed in claim 8, wherein said second amorphous layer (4) has a thickness greater than that of said first monocrystalline layer (3).

## Patentansprüche

1. Verfahren zur Herstellung eines Halbleiterwafers, welches die Schritte der Ausbildung einer ersten amorphen Lage (2) einer Halbleiterverbindung der Gruppe III-V auf einem Silizium-Substrat (1) und die Bildung einer ersten einkristallinen Lage (3) der Halbleiterverbindung auf der amorphen Lage (2) aufweist;
**gekennzeichnet** durch die weiteren Schritte der Bildung einer zweiten amorphen Lage (4) der Halbleiterverbindung auf der ersten Einkristallage (3) und Erzeugen eines Epitaxiewachstums aus der festen Phase aus der ersten einkristallinen Lage (3) durch die zweite amorphe Lage (4), um dadurch die zweite amorphe Lage (4) in die zweite einkristalline Lage (4a) der Halbleiterverbindung umzuformen.

2. Verfahren nach Anspruch 1, wobei die Halbleiterverbindung der Gruppe III-V aus der Gruppe gewählt ist, die GaAs, GaP, GaAsₓP₁₋ₓ, InₓGa₁₋ₓAs, InₓGa₁₋ₓAsₓP₁₋ₓ und InP enthält.

3. Verfahren nach Anspruch 1 oder 2, wobei die erste amorphe Lage (2) eine Dicke von etwa 10 nm bis 20 nm hat und bei einer Temperatur im Bereich von 400°C bis 450°C gebildet wird.

4. Verfahren nach einem der vorangehenden Ansprüche, wobei die zweite amorphe Lage (4) eine Dicke von etwa 2 µm bis 5 µm hat und bei einer Temperatur im Bereich von 400°C bis 450°C gebildet wird.

5. Verfahren nach einem der vorangehenden Ansprüche, wobei das Epitaxiewachstum der festen Phase nach der Ausbildung der zweiten amorphen Lage (4) durch die Ausführung eines Temperungsprozesses bei einer Temperatur bewirkt wird, die tiefer ist als die, bei der die erste einkristalline Lage (3) ausgebildet wurde.

6. Verfahren nach Anspruch 5, wobei die Temperatur im Bereich von etwa 500°C bis etwa 600°C liegt.

7. Verfahren nach einem der vorangehenden Ansprüche, welches durch die Verwendung eines metallorganischen chemischen Dampfabscheidungsprozesses (MOCVD) oder eines Molekularstrahlepitaxie-Prozesses (MBE) ausgeführt wird.

8. Verfahren nach einem der vorangehenden Ansprüche, wobei die Ausbildung der ersten amorphen Lage (2) bei einer ersten Temperatur, die Bildung der ersten einkristallinen Lage (3) bei einer zweiten Temperatur, die über der ersten Temperatur liegt, die Bildung der zweiten amorphen Lage (4) bei einer dritten Temperatur, die unter der zweiten Temperatur liegt, und die Umformung der zweiten amorphen Lage (4) in die zweite einkristalline Lage (4a) bei einer vierten Temperatur ausgeführt wird, die zwischen der zweiten und der dritten Temperatur liegt.

9. Verfahren nach Anspruch 8, wobei die zweite amorphe Lage (4) eine Dicke hat, die größer ist als die der ersten einkristallinen Lage (3).

## Revendications

1. Procédé de fabrication d'une pastille de semiconducteur comprenant les étapes d'un procédé de fabrication d'une pastille de semiconducteur comprenant les étapes de formation d'une première couche amorphe d'un composé semiconducteur d'éléments des groupes III-V sur un support de silicium et formation d'une première couche monocristalline dudit composé semiconducteur sur ladite couche amorphe ; caractérisé par les étapes supplémentaires de formation d'une seconde couche amorphe dudit composé semiconducteur sur la première couche monocristalline et production d'un grossissement épitaxial en phase solide, depuis ladite première couche monocristalline, à travers ladite seconde couche amorphe de manière à transformer cette seconde couche amorphe en une seconde couche monocristalline dudit composé semiconducteur.

2. Procédé selon la revendication 1, dans lequel ledit composé semiconducteur d'éléments des groupes III-V est choisi parmi GaP, GaAsₓPP₁₋ₓ, InₓGa₁₋ₓ, InₓGa₁₋ₓAsₓP₁₋ₓ et InP.

3. Procédé selon la revendication 1 ou 2, dans lequel ladite première couche amorphe (2) a une épaisseur d'environ 10 à 20 nm et elle est formée à une température dans l'intervalle de 400 à 450°C.

4. Procédé selon l'une quelconque des revendications précédentes dans lequel ladite seconde couche amorphe (4) a une épaisseur d'environ 2 à 5 µm et elle est formée à une température dans l'intervalle de 400 à 450°C.

5. Procédé selon l'une quelconque des revendications précédentes, dans lequel le grossissement épitaxial en phase solide est produit après la formation de ladite seconde couche amorphe (4) en mettant en oeuvre un procédé de recuit à une température inférieure à celle à laquelle on a formé ladite première couche monocristalline (3).

6. Procédé selon la revendication 5, dans lequel ladite température est dans l'intervalle d'environ 500 à environ 650°C.

7. Procédé selon l'un quelconque des revendications précédentes, mis en oeuvre en utilisant un procédé de déposition en phase vapeur par réaction chimique de composé organométallique (MOCVD) ou un procédé d'épitaxie par faisceau moléculaire (MBE).

8. Procédé selon l'une quelconque des revendications précédentes dans lequel la formation de ladite première couche amorphe (2) est effectuée à une première température, la formation de ladite première couche monocristalline (3) est effectuée à une seconde température supérieure à ladite première température, la formation de ladite seconde couche amorphe (4) est effectuée à une troisième température inférieure à ladite seconde température et la transformation de ladite seconde couche amorphe (4) en ladite seconde couche monocristalline (4a) est effectuée à une quatrième température comprise entre ladite seconde température et ladite troisième température

9. Procédé selon la revendication 8 dans lequel ladite seconde couche amorphe (4) a une épaisseur supérieure à celle de ladite première couche monocristalline (3).
